# EUROPEAN PATENT APPLICATION

(11) **EP 1 463 207 A1**
(43) Date of publication of application: **29.09.2004**
(21) Application number: 04251713.6
(22) Date of filing: 24.03.2004
(51) Int. Cl.: H03M 13/41

(54) **Viterbi decoding for convolutional encoded signals with scattering of known bits**

(30) Priority: 27.03.2003 GB 0307090
(71) Applicant: Tandberg Television ASA, 1326 Lysaker (NO)
(72) Inventor: Huggett, Anthony Richard, Eastleigh, Hampshire SO50 5PZ (GB)
(74) Representative: Molyneaux, Martyn William

(57) **Abstract**

A convolutional encoded signal, having at least one predetermined bit at a predetermined bit location in the signal, is decoded, taking into account the at least one predetermined bit (101). As in a known Viterbi decoder, error coefficients are determined, representative of differences between successively received encoded symbols of the encoded signal, representative of transitions of the state of an encoder with which the signal was encoded, and predetermined permitted transitions from the said states. Sums of error coefficients (93, 94) corresponding to successions of transitions are determined to find a succession of transitions having a least sum, representative of a least error decoded signal. However, states which are inconsistent with the predetermined bit at the predetermined bit location are effectively discounted, as are any transitions passing through such a state. This may be visualised as constraining a Viterbi trellis in the vicinity of the at least one predetermined bit.

## Description

This invention relates to decoding a signal encoded with a convolutional code.

The use of a Viterbi decoder for decoding a signal, or data stream, which has been convolutionally encoded for forward error correction, is well known. In a convolutional encoder, output symbols are produced consisting of a plurality of output bits. Optionally, one of the output bits may be the same as a current input bit. The remaining output bits are produced dependent on the current input bit and at least one of a successive plurality of preceding input bits. The convolutional encoder may be considered as a state machine in which an encoded output produced in response to an input bit is dependent on the current state of the state machine and the input bit itself. For a binary original signal, for any given state of the state machine only two transitions to two new states are valid, dependent, for example, on whether the input bit is a 0 or a 1. The Viterbi algorithm may be used to decode a convolutionally encoded signal (which may contain noise due to the channel) by determining the most likely sequence of states given the sequence of received symbols.

It may be the case that there is prior knowledge of the actual values of some of the bits which were input to the convolutional encoder. For example these might arise from the presence of repeating higher level system synchronisation marks within the data stream. Methods exist for finding these marks within a noisy convolutionally encoded stream prior to the input to a Viterbi decoder, but are outside the scope of this invention. We will herein refer to the known or determinable bits as fixed bits. A Viterbi decoder according to the prior art does not take advantage of this information.

It is an object of the present invention at least to ameliorate the aforesaid deficiency in the prior art.

According to a first aspect of the invention, there is provided a method of decoding a received signal encoded with a convolutional encoder from an original signal having at least one predetermined bit at a predetermined bit location in the original signal, by determining from the received signal a most probable sequence of states of the encoder consistent with a predetermined generator polynomial of the encoder and with the at least one predetermined bit at the predetermined bit location., the method comprising the steps of (a) for each received encoded symbol representative of a bit in the original signal, adding, for each possible current state, error coefficients representative of differences between the received encoded symbol, representative of a transition from a previous state of the encoder to a current state, and expected symbols corresponding to predetermined alternative permitted transitions from previous states to the current state, to a sum of such error coefficients for said previous states to form updated sums of such error coefficients for each of a new plurality of state sequences for all possible states; (b) if the bit is a predetermined bit, for every state, selecting both a most probable state sequence ending in that state from the new plurality of state sequences and a corresponding updated sum of error coefficients according to said predetermined bit, thereby discounting, at the bit location in the encoded signal corresponding to the predetermined bit location in the original signal, any state inconsistent with the predetermined bit at the predetermined bit location; (c) if the bit is not a predetermined bit, for every state, comparing said updated sums of error coefficients and selecting an updated sum of error coefficients representing a lesser total of said differences between the received encoded symbols and the expected symbols and selecting a corresponding most probable state sequence ending in that state from the new plurality of state sequences; (d) determining a best current state for the bit in the original signal by either comparing the updated sums of error coefficients of the most probable state sequences for every state or choosing a state arbitrarily; and (e) thereby determining, by tracing back from the best current state, a most probable earliest transition and earliest state that occurred a predetermined plurality of symbols previously, and thereby finding and outputting a bit most probably equal to the bit in the original signal.

Conveniently, the at least one predetermined bit at a predetermined bit location is a synchronisation bit.

According to a second aspect of the invention, there is provided a decoder for decoding a signal encoded with a convolutional encoder from an original signal having at least one predetermined bit at a predetermined bit location in the original signal, comprising: receiving means for receiving encoded symbols of the encoded signal; summing means for adding for each received encoded symbol representative of a bit in the original signal, and for each possible current state of the convolutional encoder, error coefficients representative of differences between the received encoded symbol, representative of a transition from a previous state to a current state, and expected symbols corresponding to predetermined alternative permitted transitions from previous states to the current state, to a sum of such error coefficients for the previous states to form updated sums of such error coefficients for each of a new plurality of state sequences for all possible states; comparing and selecting means for selecting for every state: if the bit is a predetermined bit, both a most probable state sequence ending in that state from the new plurality of state sequences and a corresponding updated sum of error coefficients according to the predetermined bit, thereby discounting, at the bit location in the encoded signal corresponding to the predetermined bit location in the original signal, any state inconsistent with the predetermined bit at the predetermined bit location; and, if the bit is not a predetermined bit, for every state, comparing said updated sums of error coefficients and selecting an updated sum of error coefficients representing a lesser total of said differences between the received encoded symbols and the expected symbols and selecting a corresponding most probable state sequence ending in that state from the new plurality of state sequences; processing means for determining a best current state for the bit in the original signal by either comparing the updated sums of error coefficients of the most probable state sequences for every state or choosing a state arbitrarily; and thereby determining, by tracing back from the best current state, a most probable earliest transition and earliest state that occurred a predetermined plurality of symbols previously, and thereby finding a bit most probably equal to the bit in the original signal; and transmitting means for outputting said bit most probably equal to the bit in the original signal.

Preferably, the decoder is arranged for generating a Viterbi state trellis corresponding to the convolutional encoder and for determining error coefficients of transition paths of the encoded signal through the Viterbi state trellis.

Conveniently, the decoder comprises synchronisation recognition means for recognising a synchronisation bit in the encoded signal for the comparing and selecting means to use the synchronisation bit as the at least one predetermined bit at a predetermined bit location.

According to a third aspect of the invention, there is provided a computer program comprising code means for performing all the steps of the method described above when the program is run on one or more computers.

The invention will now be described, by way of example, with reference to the accompanying drawings in which:
Figure 1 is a diagrammatical representation of a convolutional encoder suitable for use with the present invention;
Figure 2 is a trellis representation of encoder states, helpful in understanding the present invention, showing a single set of transitions of encoder states;
Figure 3 is a trellis representation of encoder states, helpful in understanding the present invention, showing a plurality of sets of transitions of encoder states, in which no bits are known;
Figures 4A and 4B are trellis representations of encoder states, suitable for use in the present invention, showing a modified plurality of sets of transitions of encoder states, in which one bit is known;
Figures 5A and 5B are trellis representations of encoder states, suitable for use in the present invention, showing a modified plurality of sets of transitions of encoder states, in which two non-consecutive bits are known;
Figures 6A, 6B and 6C are trellis representations of encoder states, suitable for use in the present invention, showing a modified plurality of sets of transitions of encoder states, in which two consecutive bits are known;
Figure 7 is a flowchart of an add, compare and select procedure used in Viterbi decoding in the prior art;
Figure 8 is a flowchart of the add, compare and select procedure of Figure 7 modified according to the invention;
Figure 9 is a schematic diagram of the inputs and outputs of a Add-Compare-Select block of a known Viterbi decoder; and
Figure 10 is a schematic diagram of the inputs and outputs of a Add-Compare-Select block of a Viterbi decoder according to the invention.

In the Figures, like reference numerals denote like parts.

Known convolutional encoders may be defined in terms of their rate, that is the proportion of input bits to output symbols, and their constraint length, that is the number of input bits on which each output symbol is dependent. Outputs of the encoder are dependent on coefficients of a predetermined generator polynomial which determines which of a series of successive input bits are added to form corresponding output symbols.

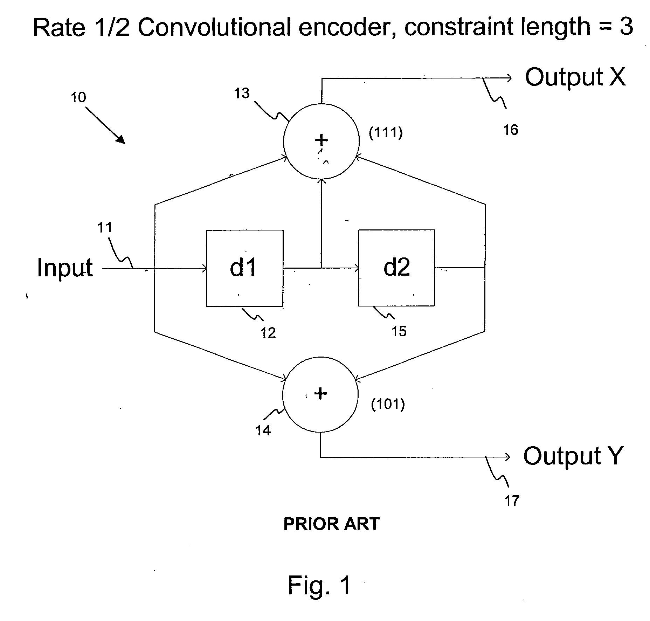

Figure 1 shows a known ½ rate convolutional encoder 10, i.e. having two output symbols for each input bit, with a constraint length of 3. An input 11 of the encoder is connected to an input of a first memory element 12 and to first inputs respectively of a first modulo-2 adder 13 and a second modulo-2 adder 14. An output of the first memory element 12 is connected to an input of a second memory element 15 and a second input of the first modulo-2 adder 13. An output of the second memory element 15 is connected to a third input of the first modulo-2 adder 13 and a second input of the second modulo-2 adder 14. An output of the first modulo-2 adder is connected to a first output 16 of the encoder and an output of the second modulo-2 adder is connected to a second output 17 of the encoder. Output bits are read from the first output 16 and the second output 17 alternately to form a two-bit output symbol dependent on a current one-bit input and the two preceding input bits in a manner to be described.

The first memory element 12 contains an input bit d1 received immediately previously to a current input bit and the second memory element 15 contains an input bit d2 received immediately previously to input bit d1. Since the bit output to the first encoder output 16 is determined by adding the input bit and two immediately preceding input bits d1, d2 stored in the first and second memory elements 12, 15 respectively, the first output is said to have a generator polynomial coefficient of 111 and since the bit output to the second output 17 is determined by adding the current input bit and the preceding input bit d2 stored in the second memory elements 15, but not the immediately preceding input bit d1, the second output is said to have a generator polynomial coefficient of 101.

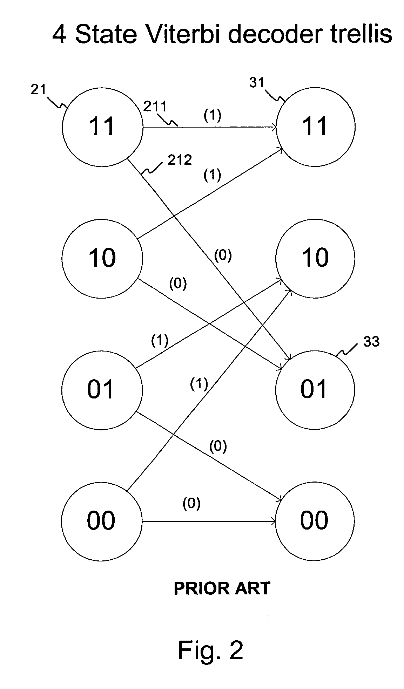

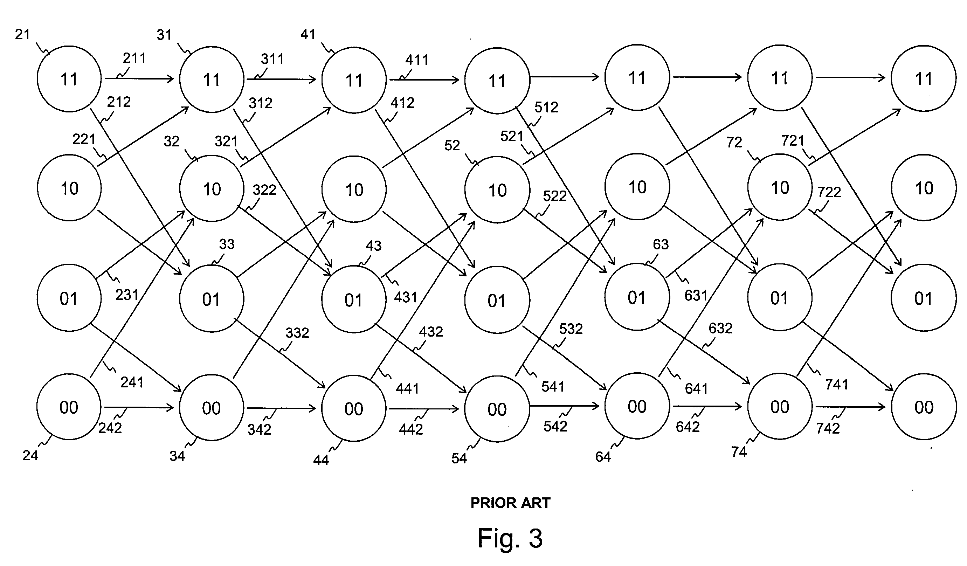

A state of the encoder 10 may be represented at any time by the contents d1, d2 of the first and second memory elements 12, 15. Thus if d1=1 and d2=1 the state of the encoder 10 is said to be equal to 11. In the illustrated case of an encoder having constraint length 3 there are therefore four possible states 11, 10, 01 and 00 of the encoder. Only two possible transitions exist from one state to a next state, dependent upon whether the input bit is a 0 or a 1. Figure 2 shows a state trellis diagram of the possible state transitions dependent on an initial state and an input bit received. Thus with, for example, d1=1 and d2=1 the encoder is in state 21 equal to 11 and if an input bit is a1, the content of the first memory element is moved into the second memory element, so that d1 remains 1, and the input bit is moved into the first memory element, so that d2 remains 1 and the encoder undergoes a transition 211 from state 21 equal to 11 to state 31 equal to 11, whereas if the input bit is 0 the encoder undergoes a transition 212 from state 21 equal to 11 to state 33 equal to 01. Figure 3 is similar to Figure 2, but is expanded to represent the possible transitions corresponding to the receipt of six successive output symbols, which may be used to represent known Viterbi decoding.

The Viterbi decoder operates iteratively as follows. At every time instant each state has a pointer to the previous state in the best sequence of states, or path, that finishes in this state. It follows that there are as many paths as there are states. Each state also has an associated path metric which represents the probability of all the received symbols up to the current one assuming that the encoder passed through the most probable path that finishes in that state. By Bayes' rule this is equivalent to the probability of the best path finishing in this state given all the received symbols, multiplied by some constants which are hard to calculate (and which may be ignored). It is convenient (and usual practice) to use a logarithmic number representation, thus multiplication of probabilities is replaced by addition of metrics.

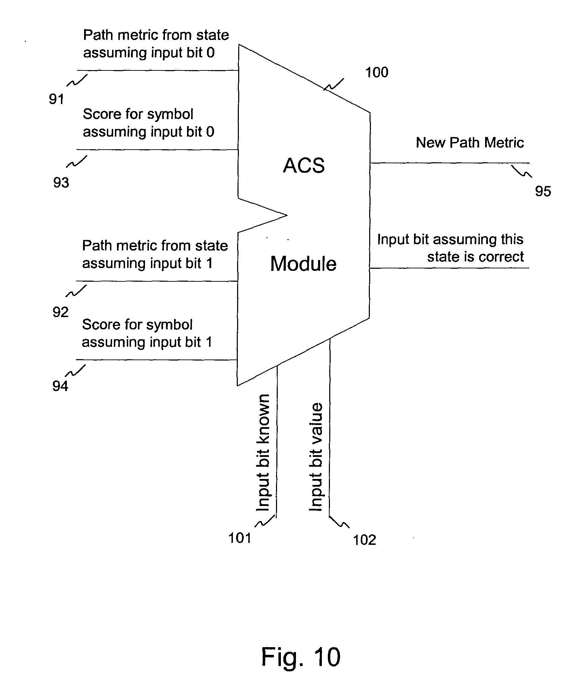

Referring to Figure 9, showing the input and output signals of a known Add-Compare-Select (ACS) block, at a next time instant, i.e. when a new symbol is received, a new set of path metrics are calculated, one for each state, using an (ACS) operation 90. For each new state the ACS operation generates a result for each of the two possible previous states by adding the metric 91, 92 associated with that state to a score 93, 94 which depends on the received symbol and the expected symbol given the transition from that previous state to this state. The ACS operation then compares these results and selects the best, storing the result of this decision as the last transition in the best path to this state, as well as the new metric 95. Once all the new metrics have been calculated the old metrics no longer need to be stored, and the next received symbol can be processed. This means that for every symbol the ACS operation has to be performed to compute the path metric to every state and to decide which is the best previous state in the best path to that state.

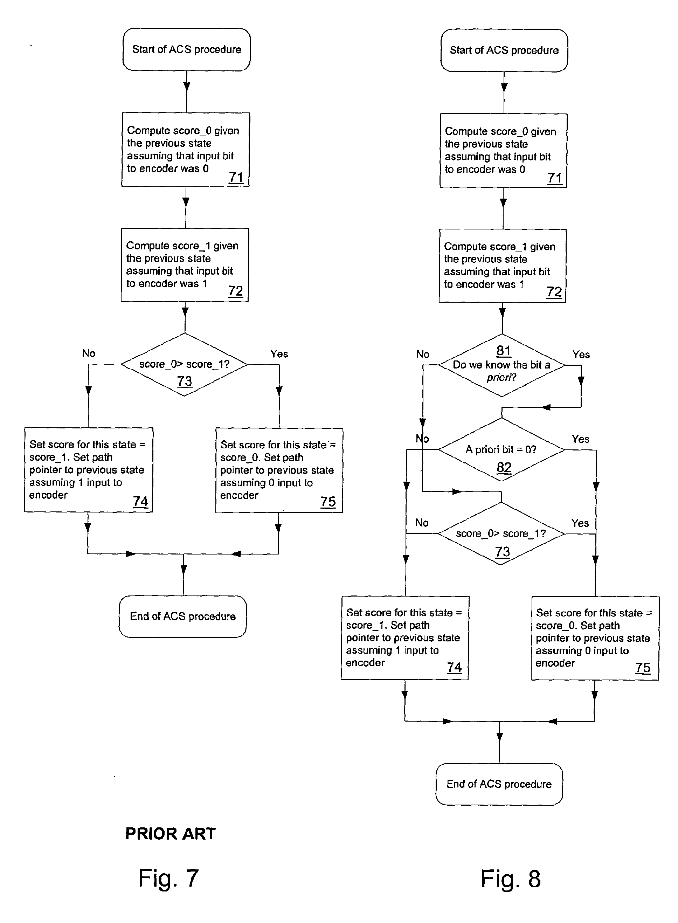

This ACS procedure is illustrated in the flowchart of Figure 7. On receipt of a symbol, a score_0 is calculated, step 71, by adding the path metric for the unique previous state which is consistent with the assumption that the corresponding input bit to the encoder was 0, to a score based on the negative squared Euclidean distance between the received symbol and the expected symbol given the supposed previous state. A score_1 is also calculated, step 72, in an identical manner assuming that the corresponding input bit to the encoder was 1. The two scores are compared, step 73, and if score_1 is greater than score_0, the score for the state is set, step 74, to score_1 and a transition path to the previous state is set assuming the original input bit was 1. If, on the other hand, score_0 is greater than score_1, the score for the state is set, step 75, to score_0 and the transition path to the previous state is set assuming the original input bit was 0. It is the nature of the algorithm that if the paths are traced back far enough, all of the paths will have converged to the same state. To determine the output bit from the Viterbi decoder associated with a particular symbol it is necessary to wait until many more symbols have been processed and then to look back at the trellis to see the converged path. The decoded bits may then be simply determined as the transitions along this path.

For a real decoder it is necessary to impose a finite limit on the length of the trace back; typically a number of symbols between 5 and 10 times the constraint length are received before determining the state and hence the output bit. Most commonly this is done by choosing a best state, and tracing back as far as the path memory will allow to find the first transition in that path. Preferentially the best state is the state with the best score, but it may be an arbitrary state (e.g. all 0's) for simplicity. For continuous operation this trace back operation to the earliest transition in the best path is performed once for every input symbol.

The decoder algorithm may be started either in a known state or with all states equiprobable.

In some signals or data streams some input bits, such as synchronization bits, are known or can be recognised or determined from the encoded signal. In the decoding method of the invention the selection operation is overridden using such fixed bit information; that is the best previous state is chosen taking account of the fixed bit. The score for this state is set corresponding to this decision. In a preferred implementation the fixed bit is chosen as the final bit in the previous state (i.e. d2 in the example below).

Referring to Figure 10, showing the input and output signals of a modified ACS block 100 according to the invention, a first signal 101 indicating that the bit is known and a second signal 102 indicating the value of the known bit are also input to the ACS block. The determination that a bit is known may be made simply by checking a first signal carrying the message "this bit is fixed" and if so inputting a second signal carrying a "this bit has value x" message to drive the ACS block 100. The modified ACS procedure according to the invention is illustrated in Figure 8. Having computed, steps 71 and 72, score_0 and score_1 as in the unmodified ACS procedure it is determined, step 81, whether the original bit is a fixed bit. As indicated above, such determination may constitute reading an accompanying signal indicating whether or not the bit is fixed, and, if so, the value of the bit. If the original bit is not a fixed bit, then the procedure continues as in the unmodified ACS procedure of comparing, step 73, the two scores and setting, steps 74, 75, the state and transition path accordingly. If, however, it is determined, step 81, that the original bit is a fixed bit, it is determined, step 82, whether the fixed bit is a 0 or 1. If the fixed bit is 1, the score for the state is set, step 74, to score_1 and a transition path to the previous state is set knowing the original input bit was 1. If, on the other hand, the fixed bit is 0, the score for the state is set, step 75, to score_0 and the transition path to the previous state is set knowing the original input bit was 0.

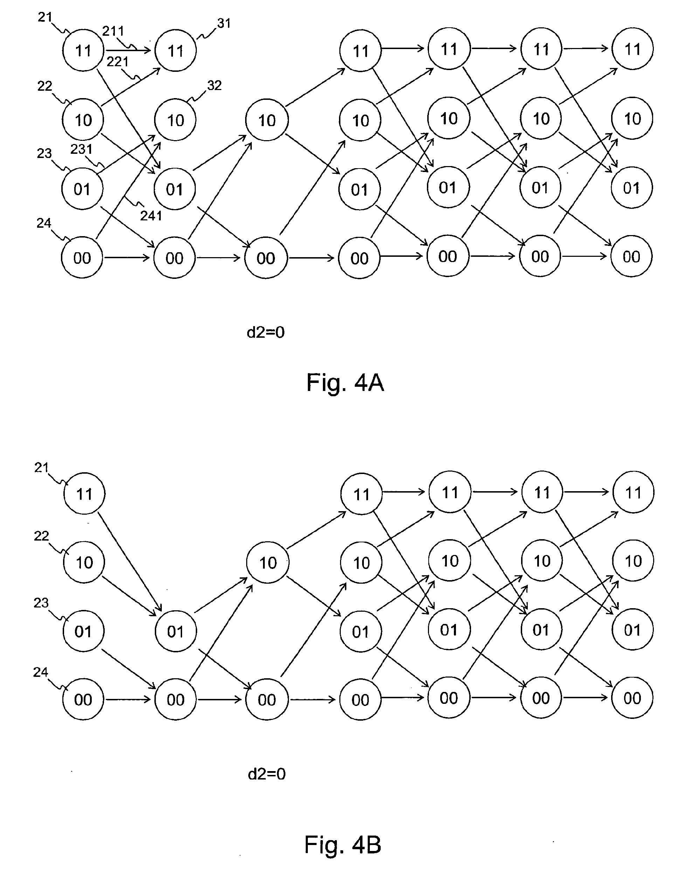

By way of example, consider that it is known that after the second transition at time step 2 d2=0. Then, referring to Figures 3 and 4A, it is known that the states 41, 43 equal to 11 (i.e. d1=1,d2=1) and 01 (i.e. d1=0, d2=1) respectively in the third column (representing the states after time step 2) of the trellis cannot be valid, since they have d2=1, so that those states and any transactions leading to them 311,321; 312,322 or from them 411,412; 431,432 may effectively be removed or discounted when comparing paths through the trellis. Similarly, as shown in Figure 4B compared with Figure 3, states 31, 32, equal to 11 and 10 in the second column (representing the states after time step 1) in the example illustrated, which no longer have any transitions leading from them may also be effectively removed or discounted, together with any transactions 211,221; 231,241 leading to them, thereby reducing a number of paths through the trellis which need to be compared, and increasing the confidence with which adjoining bits may be decoded.

In practice, the effect of the fixed bit override is on the ACS module itself. The implications for a search through the trellis follow automatically from the behaviour of the Viterbi algorithm - it is not necessary actually to remove or discount states - indeed it would be computationally expensive to do so.

Referring to Figure 4A compared with Figure 3, state 43 equal to 01 and state 41 equal to 11 are removed from consideration after time step 2 simply by constraining the decisions made at each of the four states after time step 3. It follows that the Viterbi algorithm itself will remove paths through states 31 and 32 - it is not necessary to engage in expensive trellis pruning operations.

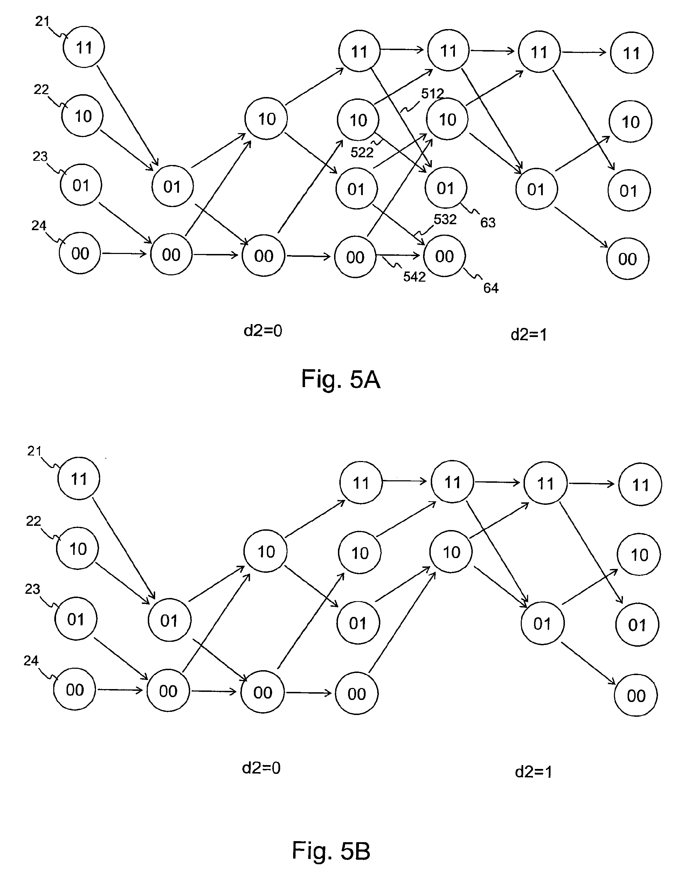

Figures 5A and 5B illustrate the effect of two, non-consecutive bits being known. In addition to the states 31,32; 41,43 which are effectively removed from consideration after time steps 1 and 2 in the second and third columns, since, as in the previous example, d2=0 after the second transition, if it is known that in the sixth column that d2=1, then the states 72,74 equal to 10 and 00 and their corresponding transitions 631,641; 632,642 leading to the states and transitions 721,722; 741,742 leading from the states can effectively be disregarded, as shown in Figure 5A compared with Figure 3, and also states 63, 64 equal to 01 and 00 in the preceding column, which no longer have valid transitions leading from them, may also effectively be disregarded, together with transitions 512,522; 532,542 leading to them, as shown in Figure 5B compared with Figure 3.

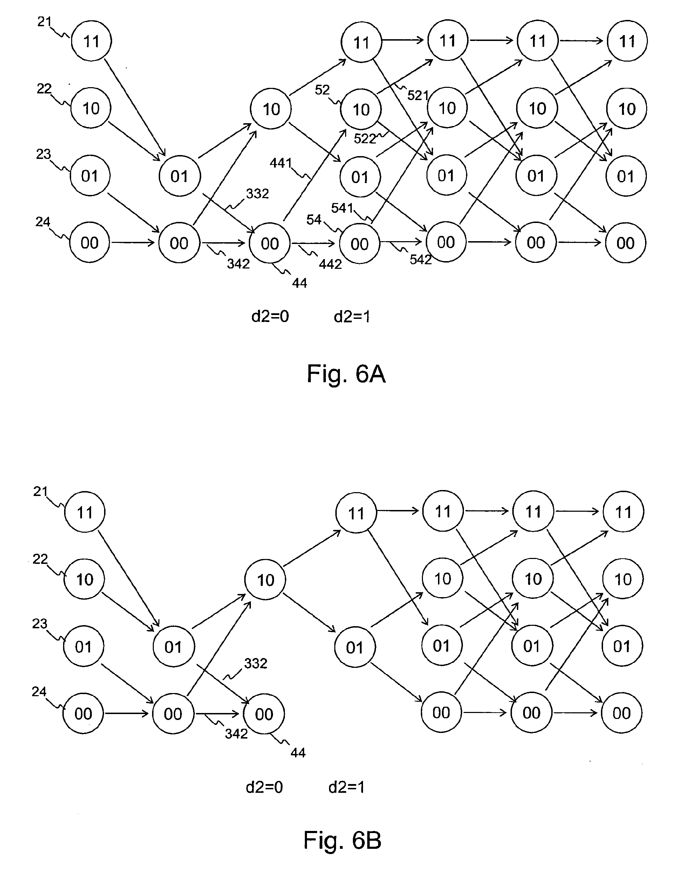

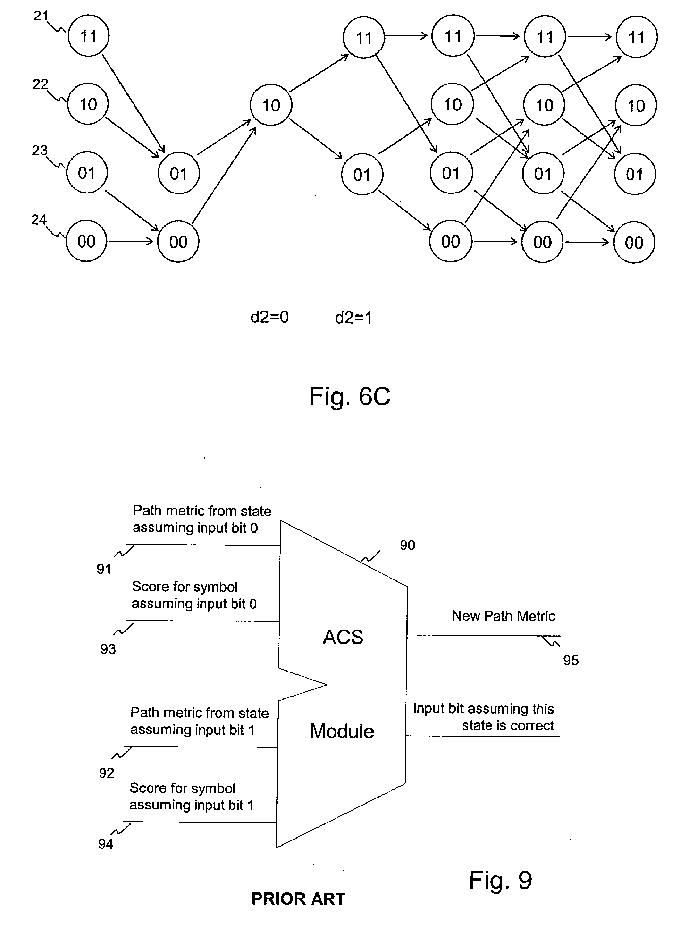

Figures 6A, 6B and 6C illustrate the effect of two consecutive bits being known. In addition to the states 31,32; 41,43 which are effectively removed from consideration in the second and third columns, as in the previous two examples since d2=0 after the second transition, as illustrated in Figure 6A, if it is known that after the third transition d2= 1, then the states 52,54 equal to 10 and 00 and their corresponding remaining transitions 441,521,522; 442,541,542 can be disregarded as shown in Figure 6B, and also the state 44 equal to 00 in the preceding column, which no longer has a valid transition leading from it, may also effectively be disregarded, as shown in Figure 6C, together with the transitions 332,342 leading to the state 44.

As explained above in respect to the case illustrated in Figure 4, it is not necessary actually to remove or discount states in either of the cases illustrated in Figures 5 and 6.

Although the invention has been described in relation to a non-recursive non-systematic rate 1/2 encoder with a constraint length of 3, it will be understood that the invention is not limited to a particular rate, puncturing pattern or constraint length. The invention is equally applicable to systematic convolutional codes and/or recursive codes. Moreover, although the invention has been described in terms of a Viterbi trellis, it will be understood that the Viterbi trellis is merely a means of visualising the operation of a Viterbi decoder and does not limit the general applicability of the invention.

The invention provides the following advantages:
i) Fixed bits are always decoded without error by the decoder.
ii) The likelihood of bits near to the fixed bits being correctly decoded is improved due to the restriction that the known bits place upon available decisions, i.e. transition paths, through the Viterbi decoder i.e. the search.
iii) Long bursts of errors, typically produced by a Viterbi decoder, even though the input noise is uncorrelated in time, are reduced by the presence of the fixed bits. If the fixed bits occur together in groups that are longer than a memory depth of the encoder, then the successive fixed bits cause a fixed state. Bursts of errors cannot propagate through this fixed state.

The effect of ii) and iii) above is a reduced bit error ratio in the unfixed bits output from the Viterbi decoder compared with a case when the decoder cannot make use of fixed bit information.

## Claims

1. A method of decoding a received signal (16, 17) encoded with a convolutional encoder (10) from an original signal (11) having at least one predetermined bit (101) at a predetermined bit location in the original signal, by determining from the received signal (16, 17) a most probable sequence of states of the encoder consistent with a predetermined generator polynomial of the encoder (10) and with the at least one predetermined bit (101) at the predetermined bit location., the method comprising the steps of:
a) for each received encoded symbol representative of a bit in the original signal, adding (71, 72), for each possible current state, error coefficients representative of differences between the received encoded symbol, representative of a transition from a previous state of the encoder to a current state, and expected symbols corresponding to predetermined alternative permitted transitions from previous states to the current state, to a sum of such error coefficients (93, 94) for said previous states to form updated sums of such error coefficients for each of a new plurality of state sequences for all possible states;
b) if the bit is a predetermined bit (101), for every state, selecting (82, 74, 75) both a most probable state sequence ending in that state from the new plurality of state sequences and a corresponding updated sum of error coefficients according to said predetermined bit (101), thereby discounting, at the bit location in the encoded signal corresponding to the predetermined bit location in the original signal, any state inconsistent with the predetermined bit at the predetermined bit location;
c) if the bit is not a predetermined bit, for every state, comparing (73) said updated sums of error coefficients and selecting (74, 75) an updated sum of error coefficients representing a lesser total of said differences between the received encoded symbols and the expected symbols and selecting a corresponding most probable state sequence (95) ending in that state from the new plurality of state sequences;
d) determining a best current state for the bit in the original signal by either comparing the updated sums of error coefficients of the most probable state sequences for every state or choosing a state arbitrarily; and
e) thereby determining, by tracing back from the best current state, a most probable earliest transition and earliest state that occurred a predetermined plurality of symbols previously, and thereby finding and outputting a bit most probably equal to the bit in the original signal.

2. A method as claimed in claim 1, wherein the at least one predetermined bit (101) at a predetermined bit location is a synchronisation bit.

3. A decoder for decoding a signal (16, 17) encoded with a convolutional encoder (10) from an original signal (11) having at least one predetermined bit (101) at a predetermined bit location in the original signal, comprising:
receiving means for receiving encoded symbols of the encoded signal;
summing means (100) for adding for each received encoded symbol representative of a bit in the original signal, and for each possible current state of the convolutional encoder, error coefficients representative of differences between the received encoded symbol, representative of a transition from a previous state to a current state, and expected symbols corresponding to predetermined alternative permitted transitions from previous states to the current state, to a sum of such error coefficients for the previous states to form updated sums of such error coefficients (93, 94) for each of a new plurality of state sequences for all possible states;
comparing and selecting means (100) for selecting for every state:
if the bit is a predetermined bit (101), both a most probable state sequence ending in that state from the new plurality of state sequences and a corresponding updated sum of error coefficients according to the predetermined bit, thereby discounting, at the bit location in the encoded signal corresponding to the predetermined bit location in the original signal, any state inconsistent with the predetermined bit at the predetermined bit location; and, if the bit is not a predetermined bit, for every state, comparing said updated sums of error coefficients and selecting an updated sum of error coefficients representing a lesser total of said differences between the received encoded symbols and the expected symbols and selecting a corresponding most probable state sequence ending in that state from the new plurality of state sequences;
processing means for determining a best current state for the bit in the original signal by either comparing the updated sums of error coefficients of the most probable state sequences for every state or choosing a state arbitrarily; and thereby determining, by tracing back from the best current state, a most probable earliest transition and earliest state that occurred a predetermined plurality of symbols previously, and thereby finding a bit most probably equal to the bit in the original signal; and
transmitting means for outputting said bit most probably equal to the bit in the original signal.

4. A decoder as claimed in claim 3, arranged for generating a Viterbi state trellis corresponding to the convolutional encoder and for determining error coefficients of transition paths of the encoded signal through the Viterbi state trellis.

5. A decoder as claimed in claims 3 or 4, comprising synchronisation recognition means for recognising a synchronisation bit in the encoded signal for the comparing and selecting means (100) to use the synchronisation bit as the at least one predetermined bit (101) at a predetermined bit location.

6. A computer program comprising code means for performing all the steps of the method of claim 1 to 2 when the program is run on one or more computers.
